(19)

Europäisches
Patentamt

European
Patent Office

Office européen
des brevets

(11) **EP 3 736 859 B1**

(12) **EUROPEAN PATENT SPECIFICATION**

(45) Date of publication and mention
of the grant of the patent:
**07.06.2023 Bulletin 2023/23**

(21) Application number: **18898914.9**

(22) Date of filing: **28.11.2018**

(51) International Patent Classification (IPC):
**H01L 27/14** (2006.01)   **G02B 5/20** (2006.01)
**G02B 5/28** (2006.01)   **H01L 27/146** (2006.01)

(52) Cooperative Patent Classification (CPC):
**H01L 27/14621; G02B 5/282; G02B 5/285;**
**H01L 27/14625;** Y02E 10/52

(86) International application number:
**PCT/ES2018/070762**

(87) International publication number:
**WO 2019/135014 (11.07.2019 Gazette 2019/28)**

(54) **METHOD FOR CONFIGURING A MULTILAYER SPECTRAL-SEPARATION FILTER FOR PHOTOVOLTAIC AND THERMAL USES, AND FILTER AND GENERATION PLANT ASSOCIATED WITH SAID METHOD**

VERFAHREN ZUR KONFIGURATION EINES MEHRSCHICHTSPEKTRALTRENNUNGSFILTERS FÜR FOTOVOLTAISCHE UND THERMISCHE ANWENDUNGEN SOWIE ZUGEHÖRIGE FILTER UND ERZEUGUNGSANLAGE

PROCÉDÉ DE CONFIGURATION D'UN FILTRE MULTICOUCHE DE SÉPARATION SPECTRALE POUR DES APPLICATIONS SOLAIRES PHOTOVOLTAÏQUES ET THERMIQUES, FILTRE ET CENTRALE DE GÉNÉRATION ASSOCIÉS AUDIT PROCÉDÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Validation States:
**MA**

(30) Priority: **03.01.2018 ES 201830001**

(43) Date of publication of application:
**11.11.2020 Bulletin 2020/46**

(73) Proprietor: **Bluesolar Filters S.L**
**41018 Sevilla Sevilla (ES)**

(72) Inventor: **CAPARROS JIMENEZ, Sebastián**
**41927 Mairena del Alfarafe (Sevilla) (ES)**

(74) Representative: **ATIP**
**Armstrong Teasdale Limited**
**38-43 Lincoln's Inn Fields**
**London WC2A 3PE (GB)**

(56) References cited:
**ES-A1- 2 636 800    ES-A1- 2 636 800**

• **CHUNHUI SHOU ET AL: "Investigation of a broadband TiO/SiOoptical thin-film filter for hybrid solar power systems", APPLIED ENERGY, ELSEVIER SCIENCE PUBLISHERS, GB, vol. 92, 17 September 2011 (2011-09-17), pages 298-306, XP028356897, ISSN: 0306-2619, DOI: 10.1016/J.APENERGY.2011.09.028 [retrieved on 2011-09-22]**
• **SHOU CHUN-HUI ET AL.: "A Dielectric Multilayer Filter for Combining Photovoltaics with a Stirling Engine for Improvement of the Efficiency of Solar Electricity Generation", CHINESE PHYSICS LETTERS, vol. 28, no. 12, 1 January 2011 (2011-01-01), pages 128402-1, XP055620423, DOI: 10.1088/0256-307X/28/12/128402**
• **BABIKER SAMAH G ET AL: "Dimensional Si/Si02 photonic crystals filter for thermophotovoltaic applications", 2013 16TH INTERNATIONAL MULTI TOPIC CONFERENCE (INMIC 2013) LAHORE, PAKISTAN , 19-20 DECEMBER 2013, IEEE, US, 19 December 2013 (2013-12-19), pages 177-181, XP009522087, ISBN: 978-1-4799-3044-9**

EP 3 736 859 B1

**(Cont. next page)**

- IMENES A G ET AL: "The design of broadband, wide-angle interference filters for solar concentrating systems", SOLAR ENERGY MATERIALS AND SOLAR CELLS, ELSEVIER SCIENCE PUBLISHERS, AMSTERDAM, NL, vol. 90, no. 11, 6 July 2006 (2006-07-06), pages 1579-1606, XP028002145, ISSN: 0927-0248, DOI: 10.1016/J.SOLMAT.2005.08.007 [retrieved on 2006-07-06]
- SIBIN K P ET AL: "Design and development of ITO/Ag/ITO spectral beam splitter coating for photovoltaic-thermoelectric hybrid systems", SOLAR ENERGY, ELSEVIER LTD, vol. 141, 22 November 2016 (2016-11-22), pages 118-126, XP029862729, ISSN: 0038-092X, DOI: 10.1016/J.SOLENER.2016.11.027
- CHUNHUI SHOU et al.: "Investigation of a broadband TiO/SiOoptical thin-film filter for hybrid solar power systems", APPLIED ENERGY, vol. 92, 17 September 2011 (2011-09-17), pages 298-306, XP028356897, ISSN: 0306-2619, DOI: 10.1016/j.apenergy.2011.09.028
- SHOU CHUN-HUI et al.: "A Dielectric Multilayer Filter for Combining Photovoltaics with a Stirling Engine for Improvement of the Efficiency of Solar Electricity Generation", Chinese Physics Letters, vol. 28, 2011, XP055620423, ISSN: 0256-307X
- BABIKER SAMAH G et al.: "Dimensional Si/Si02 photonic crystals filter for thermophotovoltaic applications", 2013 16th International Multi Topic Conference (INMIC 2013), 19 December 2013 (2013-12-19), pages 177-181, XP009522087, US ISBN: 978-1-4799-3044-9
- IMENES A G et al.: "The design of broadband, wide-angle interference filters for solar concentrating systems", SOLAR ENERGY MATERIALS AND SOLAR CELLS, vol. 90, no. 11, 6 July 2006 (2006-07-06), pages 1579-1606, XP028002145, ISSN: 0927-0248
- SIBIN K P et al.: "Design and development of ITO/Ag/ITO spectral beam splitter coating for photovoltaic-thermoelectric hybrid systems", SOLAR ENERGY, vol. 141, 22 November 2016 (2016-11-22), pages 118-126, XP029862729, ISSN: 0038-092X

**Description**

**SCOPE OF THE INVENTION**

This invention refers to a method for configuring a multilayer spectral-separation filter for solar radiation to transmit said radiation to a photovoltaic (PV) cell in the ranges in which it is more efficient than a thermal receiver, such as a concentration solar power (CSP) plant and, to reflect said radiation to a thermal receiver the ranges of solar radiation in which it is more efficient than the photovoltaic cell. The main sector within which the invention is included is, therefore, that of selective treatment of solar radiation to be used in thermal and electrical energy systems of industrial plants.

**BACKGROUND OF THE INVENTION**

Within the field pertaining to solar energy generation technologies, two main groups can be distinguished: solar thermal concentration technology and solar photovoltaic generation technology. The operating principle of both is substantially different, each having its own advantages and disadvantages. Solar thermal energy is based on the use of optical components, usually mirrors, to generate concentrated light that is used to heat-up a heat transfer fluid. Said superheated fluid is used as input in a traditional turbine cycle, to heat another fluid which is the fluid that enters into said cycle. For its part, photovoltaic solar power is characterised by the use of semiconductors, mainly made from crystalline silicon, which generate direct electricity after absorbing the solar radiation via photoelectric effect.

Solar thermal energy has the great advantage that, given that it is based on fluids that act as a heating medium, they can be stored in tanks and introduced into the turbine cycle at the required time of day, or even at night. This means that solar thermal energy has the competitive advantage that it is energy that can be stored for later use. As a major disadvantage, said energy is significantly more complex to handle than solar photovoltaic energy and other conventional sources, making it more expensive to generate electricity by this means than by other sources.

Solar photovoltaic energy is, however, considerably simpler and its costs are lower than those of solar thermal power, being comparable to that of conventional sources. The great disadvantage that it presents is that, as it is a direct generation of electricity, its storage is not feasible unless batteries are used, which requires high equipment and maintenance costs. Therefore, photovoltaic energy does not enable, in practice, large-scale storage in commercial plants, which implies that the delivery of energy to the grid is not synchronised with the actual demand that may exist in said grid.

Within the area of solar thermal systems, the two technologies that currently dominate the market are the parabolic trough and the tower. In those with a parabolic trough, a conduit or tube with the fluid to be heated circulates through the focus region of one or more parabolic mirrors, which concentrate solar radiation within said conduit. In tower technology, a solar field of mirrors concentrates the radiation in a concentration region located within the tower, in which the receiver where the heat transfer fluid circulates is installed.

Parabolic trough technology is the most mature and has been the dominant technology throughout the historical development of solar thermal energy. However, recently, solar thermal towers have been prevailing, given that they have, amongst other things, the advantage that the concentration of light is more effective than in the parabolic trough and, therefore, higher temperatures can be reached and the efficiency of thermodynamic cycles can be increased. Furthermore, the circulation of heat transfer fluids is limited to the central area of the plant where the tower is located, whilst in the parabolic cylinder, being a linear system, the tubes extend entirely throughout the plant, which greatly increases its complexity. Therefore, currently, solar thermal towers have lower generation costs than the parabolic trough and are undoubtedly the future of this type of technology.

In relation to photovoltaic technology, the clearly dominant technology is that of mono- or polycrystalline silicon. These are simple systems with great economies of scale and, therefore, very cheap and which can compete in cost with conventional generation sources.

Also, the use of selective light filters is known for certain solar applications, such as those described in patent applications JP 2009218383 and US 20150083194, in which thermo-solar tower systems are described in which heliostats would be composed of photovoltaic modules. These photovoltaic modules have built-in dielectric mirrors of the "hot-mirror" type or infrared reflective films that are used as part of the elements intended to redirect sunlight to the central receiver of the tower.

These systems, however, do not currently have real commercial application given that hot-mirrors or infrared reflective films, even though they are elements that are capable of being included in reflective or collecting surfaces, present a series of disadvantages and disadvantages that prevent their use on a large scale. The reason for which these elements are not valid in the aforementioned commercial applications is explained in detail below:

- Infrared reflective films comprise a deposition of materials on a polymeric layer that subsequently adheres to the glass of the photovoltaic modules. This product configuration is not valid in commercial applications. Given that the film is exposed to external environmental conditions, it suffers a lot of degradation due to the abrasion of the environmental conditions of the area. Furthermore, such films do not guarantee specular reflection that is needed to ensure the reflected radiation is able to reach the receiver of the tower.

- Hot-mirrors comprise a deposition of dielectric materials to reflect infrared light and allow the passage of visible light. They are usually designed by selected a cut-off wavelength, typically 700-750 nm and by introducing periodic material designs to achieve very high reflectances from that cut-off wavelength. A hot-mirror is not an optimal material specification for a photovoltaic-solar thermal application, for the following reasons:

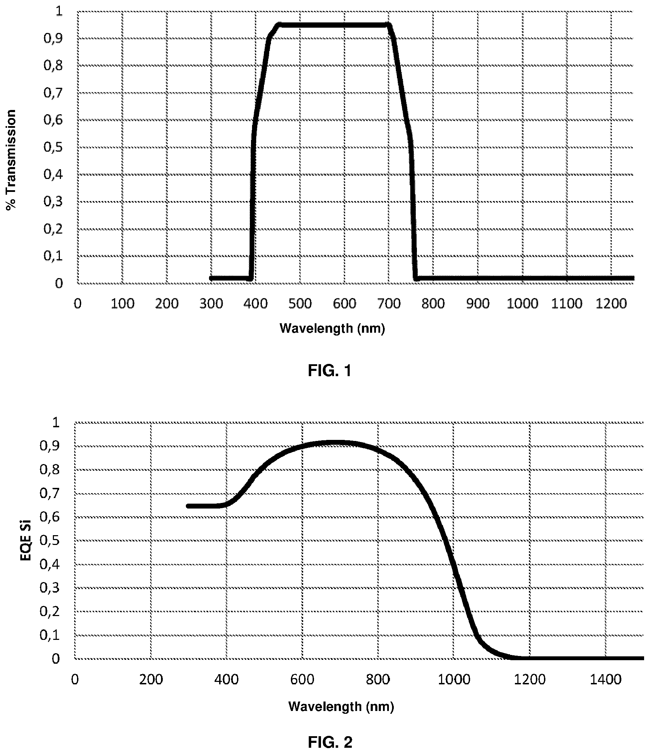

  o Infrared light starts from 700-750 nm. Figure 1 of this document shows the typical transmission curve of a hot-mirror. However, a silicon photovoltaic cell has its maximum efficiency peaks precisely in that range in which the hot-mirror would begin to reflect light, as can be seen in Figure 2, which shows the quantum efficiency of commercial silicon cells. Therefore, a very important useful significant would be subtracted from the photovoltaic cell, which drastically reduces its performance.

  ○ As mentioned, a hot-mirror seeks a maximum spectrum reflectance from approximately 700-750 nm, which is achieved by making periodic designs based on oxide thicknesses of the quarter wavelength of the range to be reflected, involving a high number of layers. A high number of layers greatly increases the price, the difficulty and the time of the deposition and makes its use unfeasible in these applications, in which the cost and the number of layers is a fundamental limiting factor.

  o In solar applications that make use of the solar spectrum, there are infrared areas in which no radiation is received, given that there are absorption peaks of water vapour. A hot-mirror would be reflecting indiscriminately in those wavelength ranges, which does not make sense given that radiation is not received, therefore it would be reflecting 100% of nothing. Those infrared reflectance zones where no radiation is received adds an unnecessary cost to the system and is further proof that they are not solutions intended for solar applications.

  ○ A hot-mirror transmits the entire visible area, including the blue area, being transparent to the human eye. An optimal photovoltaic-solar thermal application should have a material that reflects blue, given that, at these wavelengths, the quantum efficiency of silicon cells decreases and it is more efficient to reflect radiation to the thermal receiver.

Related to these stated needs, patent applications are known, such as application WO 2015117134 A1, in which parabolic trough collector systems with spectral-separation systems are proposed, in which there is, again, a lack of detail in the design claim of selective filters and obvious questions regarding spectral light separation are generically specified.

In general, the traditional criteria for designing filters has been essentially based on introducing thicknesses of a quarter of the wavelength intended to be reflected. Essentially, the usual method is to select the wavelength intended to be reflected and to calculate the thickness of the materials according to the following expressions:

$$T_H = \frac{\lambda_0}{4 n_H} \quad \text{(Eq. a)}$$

$$T_L = \frac{\lambda_0}{4 n_L} \quad \text{(Eq. b)}$$

Where T is the thicknesses, $\lambda_0$ is the wavelength that is intended to have a maximum peak of reflectance and n is the refractive indices. The reflectance width is set by the index contrast and the intensity of the reflection is controlled by adding the torque with the same thicknesses n times, until the desired peak is achieved. To extend the range of reflection, it would be necessary to take another pair of thicknesses and repeat it n times.

This design criterion for interference filters are those used in traditional optics and are those that, even without being specifically detailed in the patents related to solar plants, are shown to be used, when naming concepts such as hot-mirrors or heat-reflective films, given that these components are based on these designs and also have transmission curves identical to those that can be achieved with periodic designs.

Therefore, mainly due to the fact that the state of the art of interference filters based on traditional optics is not adapted to solar applications and is based on periodic designs, very inefficient and very expensive solutions are obtained, which present a certain degree of difficulty in their manufacture. Therefore, it is not surprising that none of the systems claimed in the aforementioned patents have found commercial application.

As an alternative to the solutions detailed above, selective sunlight filters deposited on glass as a substrate are also known, such as those described in patent application ES 2636800 A1. In this type of filters, which comprise periodically alternating layers of high and low refractive index, the incident light undergoes selective reflection to allow a majority of wavelengths to pass to a photovoltaic cell and to reflect a majority of wavelengths towards a thermal receiver. However, these filters are far from being an optimal solution for their commercial application, given that there are wavelengths that are reflected towards the thermal receiver where the semiconductors of the photovoltaic cells are still highly efficient and, therefore, are not the most efficient overall solution for a selective filter located in a hybrid solar field consisting of photovoltaic (PV) modules and a central receiver solar thermal power plant (CPS). This set of wavelengths that are no longer used in these periodic filters is blocked by the difficulty in configuring a suitable, more efficient, filter.

Due to all of the above, there is still a need to provide a selective light filter that is easy to configure and manufacture, with a low number of layers, that allows for the wavelength selection of incident sunlight with high efficiency to be adjusted, surpassing the known solutions of the state of the art; and which, as an added value, is uncomplicated and low cost. Achieving a simple, highly efficient solar filter with a low number of layers would reduce the complexity of manufacturing and repairing the filters in solar plants, given that it would require less time for the deposition of the layers and, additionally, the smaller amount of material, the simpler and cheaper it would be to replace or repair them.

This invention proposes a solution to this technical problem posed through a method for configuring a multilayer selective light filter that enables the difficulties mentioned above to be overcome, through the configuration of a highly efficient aperiodic multilayer filter within a range of desired wavelengths with low number of layers.

## BRIEF DESCRIPTION OF THE INVENTION

One aim of this invention refers, albeit without limitation, to the development of a method for configuring a multilayer spectral-separation filter for solar radiation, suitable for placement on photovoltaic panels for use in power generation plants, for using solar energy, where the multilayer filter comprises multiple layers with different refractive indices and thicknesses. Advantageously, said method involves the performance of the steps defined in Claim 1.

This is achieved by providing a tool for configuring an aperiodic multilayer filter that is highly efficient within the desired wavelength range. It is especially possible to configure a solar filter that reflects the least efficient wavelengths at the photovoltaic level and that transmits the most efficient wavelengths, maximising efficiency and, furthermore, depending on the type of semiconductor used for the photovoltaic conversion, the filter can be redesigned. Additionally, it can be redesigned under other technical criteria, still maximising efficiency.

In a preferred embodiment of the invention, the method for configuring a selective multilayer spectral-separation filter for solar radiation further involves an additional step, in which a set of secondary filters is defined. Each of those filters with a different number of layers between them, as well as a different number of layers from the first initial filter, with known refractive indices and with a random thickness of each layer; steps b) to g) are repeated to obtain an optimal multilayer filter from the secondary filter set for each given number of layers.

This is achieved by providing a set of optimal filter solutions for each given number of filter layers.

Preferably, the method of the invention further includes an additional step, where:

- a desired critical merit function is established;
- a desired critical number of layers is established;
- a final optimum filter is selected from all of the registered optimal filters in such a way that said final optimal filter is that which most closely approximates the established criteria of said critical merit function and said critical number of layers.

This makes it possible to choose an optimal filter that has a certain number of layers, such as, for example, a low number of layers, to simplify manufacturing. In this way, it is also possible to choose minimum criteria for total filter efficiency, or to reach a compromise between the number of layers and the total efficiency. Optionally, these criteria can be modified and new criteria can be established, according to the needs of the specific filter.

In a preferred embodiment of the invention, in step b) of the method of the invention, the transmittance and reflectance response of said initial filter within the desired wavelength range is calculated through the calculation of at least the following parameters:

- the characteristic matrix of a multilayer system;
- the phase term according to the wavelength, layer thickness and angle of incidence;
- the complex refractive index of a multilayer system;
- the optical admittance of a substrate on which a multilayer deposition is carried out to construct the multilayer filter.

In a preferred embodiment of the invention, in step c) of the method of the invention, the current density is calculated from the wavelength, the quantum efficiency of the cell, the charge of the electron, the Planck constant and the speed of light.

A result of operating the invention is a selective multilayer spectral-separation filter for solar radiation, suitable for maximising the efficiency of a photovoltaic and concentrated solar thermal power system, configured through a method of configuration according to any of the previous embodiments. Preferably, said multilayer filter comprises layers in aperiodic structure. More preferably, said multilayer filter is dichroic.

With this, the range of configurations of the selective light filters is greatly expanded with respect to the state of the art, given that their configuration is not restricted to a periodic design. Therefore, with an aperiodic filter, it is possible to cause reflections of different wavelengths in each layer, which increase the possible combinations resulting in the reflections, not being restricted to Fabry-Pérot reflections or to those reflections resulting from the sum of reflections of a periodic structure of known layers.

The invention also enables an ad-hoc filter to be provided for according to the specific needs that are required to select certain ranges of wavelengths and transmit or reflect in a subset of those wavelengths, also offering a range of solutions for the same conditions.

Such a multilayer filter may comprise transparent oxides of high and low refractive index. Even more preferably, the multilayer filter may comprise titanium oxide and silicon oxide or any compound derived therefrom. Yet more preferably, the silicon oxide and titanium oxide layers may have thicknesses of between 5 and 500 nm.

The multilayer filter may be configured in such a way that the wavelength ranges with minimum reflection in said aperiodic structure correspond to wavelength ranges with maximum absorption in the terrestrial solar spectrum. This is achieved by providing a filter designed for use in solar power plants comprising photovoltaic cells and comprising a thermal receiver.

The multilayer filter, may comprise a glass substrate. The deposition of the layers on the glass substrate is preferably carried out by means of the sputtering technique.

The multilayer filter may comprise between 3 and 20 layers. Preferably, the filter comprises between 3 and 10 layers. More preferably, the filter comprises between 5 and 7 layers.

Filters designed by the method of the present invention may be used in a power generation plant by harnessing solar energy that comprises the use of at least one multilayer filter configured via a configuration method according to the previous embodiments, in which at least one multilayer filter is configured to let solar radiation of visible wavelengths pass into a corresponding photovoltaic cell and to reflect solar radiation of shorter and longer wavelengths with respect to visible radiation to a central receiver.

In this way, this invention provides a solution that overcomes the problems of the state of the art, enabling the configuration of a multilayer filter specifically designed to have a high efficiency and a low number of layers, which greatly simplifies the manufacturing process and opens a door to the industrial manufacturing and marketing of these selective sunlight filters for implantation in hybrid photovoltaic and solar thermal plants.

## DESCRIPTION OF THE FIGURES

Figure 1 shows the transmission curve of a standard hot-mirror.

Figure 2 shows the typical quantum efficiency of silicon photovoltaic cells.

Figure 3 shows a diagram of a longitudinal section of an aperiodic filter and a diagram of its optical operation, according to a preferred embodiment of the invention.

Figure 4 shows both the transmittance curve and the reflectance curve of a selective light filter with a 7-layer aperiodic structure that maximises the photovoltaic and solar thermal concentration (PV-CSP) efficiency, configured by the method of the invention, according to a preferred embodiment thereof.

Figure 5 shows a diagram of a power generation plant using solar energy that comprises a photovoltaic cell and a thermal central receiver, as described in this invention.

## NUMERICAL REFERENCES USED IN THE FIGURES

In order to aid a better understanding of the technical characteristics of the invention, the Figures are accompanied by a series of numerical references where, by way of example and by no means exhaustive, the following is shown:

| (1) | Multi-layer filter |
|---|---|
| (2) | Filter layers |
| (2') | Interfaces |
| (3) | Filter substrate |
| (4) | Photovoltaic cell or PV cell |
| (5) | Thermal central receiver or concentrated solar thermal power (CSP) plant receiver |
| 100 | Incident beam |
| 101 | Resulting reflected beam |
| 102 | Parts reflected in the interfaces |
| 104 | Part of the light transmitted by the filter |

## DETAILED DESCRIPTION OF THE INVENTION

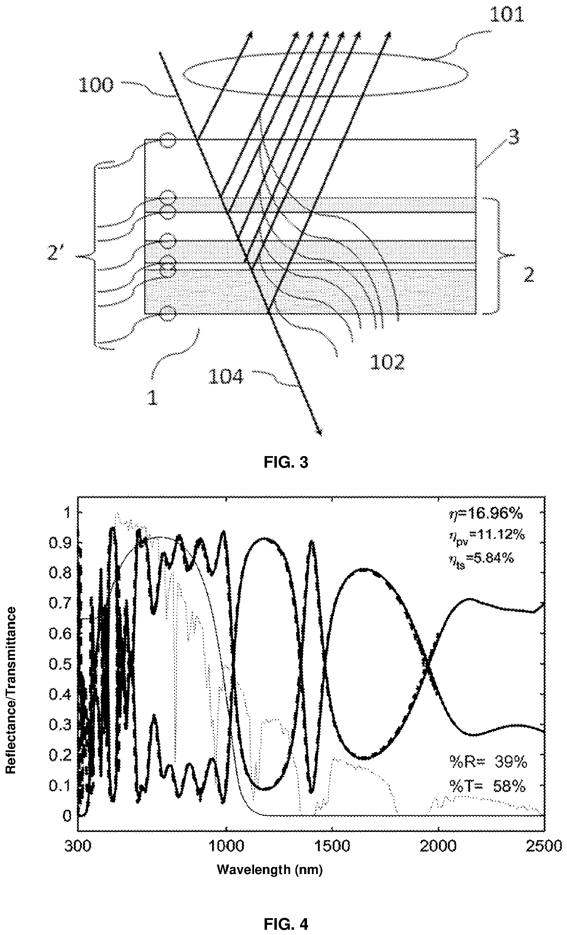

Below is a detailed description of the method and filter of the invention, referring to a preferred embodiment thereof, based on Figures 3-5 of this document. Said embodiment is provided for by way of example, but by no means exhaustive, purposes of the claimed invention.

One object of the invention relates to a method for configuring a selective sunlight multilayer filter (1) (Figure 3), preferably comprising transparent oxides (in a wavelength range of interest), with a high and low index of refraction, alternated, in an aperiodic configuration as regards its thickness in the layer structure (2) and deposited directly onto a glass substrate (3). The method of the invention therefore focuses on configuring a filter (1) which comprises a low number of layers (2) and which is optimal for:

- transmitting sunlight in its path to a photovoltaic (PV) cell (4), located adjacent to the filter (1), at the wavelengths in which the photovoltaic cell (4) is more efficient in terms of absorbing solar energy to transform it into electrical energy;

- reflecting the sunlight that reaches the filter (1) in the wavelengths in which the photovoltaic cell (4) is less efficient in terms of absorbing solar energy to transform it into electricity; and, at the same time, collecting the sunlight reflected in a thermal receiver (5), such as, for example, a concentrated solar thermal power (CSP) plant (5).

In the method for configuring the multilayer filter (1) of the invention, the known electromagnetic theory and general knowledge of solid-state physics, applied to multilayer systems such as the filter (1), to photovoltaic (PV) cells (4) adjacent to said multilayer systems, as well as photovoltaic cell (4) solar power plants and concentrated solar thermal power (CSP) plants (5) are used.

The method of the invention comprises four fundamental stages: defining an initial filter; calculating the filter response; optimising the thickness of the layers (2) for a determined number of layers (2) and optimising the number of layers (2). Each of the stages is described in detail below.

1.- Defining an initial filter.

The method requires base data, prior to optimising the multilayer filter (1). Firstly, an initial filter, j, is defined. It is assumed that said initial filter, j, is manufactured by layer-by-layer (2) deposition on a known substrate (3), for which it is necessary to choose a number, L, of layers (2) with a known random thickness:

$$t_{ij} = \{t_{ij}\} = \{t_{1j}, t_{2j}, \ldots, t_{Lj}\} \qquad (Eq.1.1)$$

Where i = 1, ..., L and $t_{ij}$ is the random initial thickness of layer (2) i of initial filter j. Each layer (2) has a known complex refractive index $N_i$, within a determined wavelength range:

$$N_i = \{N_i\} = \{N_1, N_2, \ldots, N_L\} \qquad (Eq.1.2)$$

2.- Calculating the initial filter response.

Secondly, the response of the initial filter, j, when solar radiation reaches it, must be calculated. For this, a range of wavelengths, λ, is defined within which the multilayer filter (1) is to be optimised.

Subsequently, the response of the initial filter, j, which is light selective, defined by the following equations, is calculated:

$$\delta_L = \frac{2\pi N_L t_L}{\lambda} \cos(\theta_L) \qquad (Eq.2.1)$$

$$N_L = n_L - ik_L \qquad (Eq.2.2)$$

$$\eta_S = \frac{H_S}{E_S} \qquad (Eq.2.3)$$

$$\begin{pmatrix} E_A \\ H_A \end{pmatrix} = \left\{ \prod_{L=1}^{n} \begin{pmatrix} \cos\delta_L & (i\sin\delta_L)/\eta_L \\ i\eta_L\sin\delta_L & \cos\delta_L \end{pmatrix} \right\} \begin{bmatrix} 1 \\ \eta_S \end{bmatrix} \qquad (Eq.2.4)$$

where:

- Eq. 2.4 is the characteristic matrix of a multilayer system that defines the optical response of the initial filter, j, where L refers to the layer number (2);
- $\delta_L$ is the phase term of layer L, A is the wavelength, $t_L$ is the thickness of layer L of the initial filter j and $\theta_L$ is the angle of incidence of the radiation with respect to the multilayer system;
- $N_L$ is the complex refractive index, where $n_L$ is the refractive index and $k_L$ is the extinction coefficient; both previously known.
- $\eta_s$ is the optical admittance of the substrate (3) on which the deposition of the layers (2) is carried out, which is known.
- $E_A$ is the intensity of the electric field.
- $H_A$ is the intensity of the magnetic field.

By resolving Eq. 2.4 through all the known parameters, one reaches the resolution coefficients $p_{11}$, $p_{12}$, $p_{21}$, $p_{22}$, of the characteristic matrix:

$$\begin{bmatrix} p_{11} & p_{12} \\ p_{21} & p_{22} \end{bmatrix} \qquad (Eq.2.5)$$

Given that the optical admittance of the multilayer is defined by:

$$Y = \frac{H_A}{E_A} = \frac{p_{21} + p_{22}\eta_s}{p_{11} + p_{12}\eta_s} \qquad (Eq.2.6)$$

The complex reflection coefficient can be calculated according to the following equations:

$$r = \frac{\eta_A - Y}{\eta_A + Y} \qquad (Eq.2.7)$$

$$\eta_A \text{ (s polarisation)} = N_A \cos(\Theta_A) \qquad (Eq.2.8)$$

$$\eta_A \text{ (p polarisation)} = N_A / \cos(\Theta_A) \qquad (Eq.2.9)$$

Where $\eta_A$ is the optical admittance of the medium (air, in this case) and is defined by Eq.2.8 and 2.9, depending on whether the polarisation of light is *s* or *p*.

Lastly, the total transmittance and reflectance of the initial multilayer or filter j is calculated according to the wavelength:

$$R(\lambda) = r \, x \, r \qquad (Eq.2.10)$$

$$T(\lambda) = 1 - R(\lambda) \qquad (Eq.2.11)$$

In this way, for the initial filter j with known parameters, its spectral response is characterised for a determined wavelength. This calculation can thus be applied to a discretised wavelength range of interest. Specifically, for all wavelengths in the solar spectrum, the response of the initial filter j can be calculated.

Once the spectral response of the initial filter j has been characterised for all wavelengths, the total efficiency of the initial filter j, $Ef_{total\,j}$, can be calculated in terms according to a merit with a component of photovoltaic (PV) efficiency, $Ef_{PV}$ and another thermal (CSP) efficiency component, $Ef_{CSP}$:

$$(Ef_{total\,j} = Ef_{PV\,j} + Ef_{CSP\,j} \rightarrow) \; Ef_{total} = Ef_{PV} + Ef_{CSP} \quad (Eq.2.12)$$

To calculate the photovoltaic efficiency, $Ef_{PV}$, of the initial filter j, the following expressions are used:

$$Ef_{PV} = Ef_{cel} x \, PR \qquad (Eq.2.13)$$

Where:

- PR is the typical performance ratio of photovoltaic (PV) plants, which typically has a value of around 0.8; where the losses of efficiency by cosine factor are taken into account (de-targeting with respect to the normal cosine factor of the sun); shading losses; spectral losses; losses due to irradiation; temperature losses; mismatch losses; wiring losses; losses due to the operation of the inverter; inverter efficiency losses due to operating outside the nominal point; inverter losses due to receiving power outside of its working limit; inverter losses due to voltage within its operating range; inverter losses due to receiving voltage outside its operating limit; losses due to consumption of equipment during the night; losses due to self-consumption of auxiliary equipment; losses in AC and losses due to the transformer station:

$$PR = \eta_{cos}{}^{x} \; \eta_{shade}{}^{x} \; \eta_{IAM}{}^{x} \; \eta_{dirt}{}^{x} \; \eta_{irrad}{}^{x} \; \eta_{T}{}^{x}$$
$${}^{x}\eta_{missmatch}{}^{x} \; \eta_{wiring}{}^{x} \; \eta_{inverter\_op}{}^{x} \; \eta_{inverter\,nominal}{}^{x}$$
$${}^{x}\eta_{inverter\,limit}{}^{x} \; \eta_{inverter\,voltage}{}^{x} \; \eta_{inverter\,limit\,voltage}{}^{x}$$
$${}^{x}\eta_{night\,consumption}{}^{x} \; \eta_{auxilliary\,equipment}{}^{x} \; \eta_{AC\_Ohmi}{}^{x} \; \eta_{Transformer}$$
$$(Eq.2.14)$$

- $Ef_{cel}$ is the efficiency of the photovoltaic cell according to its spectral response, which, in simple models, is usually defined by the following expression:

$$Ef_{cel} = \frac{J_{sc} x \, V_{OC} x \, FF}{GNI} \quad (Eq.2.15)$$

Where $J_{sc}$ is the current density of the photovoltaic cell, GNI is the global radiation (direct radiation plus diffuse radiation), $V_{oc}$ is the open circuit voltage of the cell and FF is the characteristic filling factor. $J_{sc}$, the current density of the photovoltaic cell, depends on the spectrum and is, in turn, defined by the following expressions in simple models:

$$J_{sc} = \Sigma_{\lambda} J_{sc}(\lambda) \qquad (Eq.\,2.16)$$

$$Jsc\ (\lambda) = \lambda x GNI(\lambda) x EQE x Transmission_{filter}(\lambda) x \frac{q}{hxc}$$

(Eq.2.17)

Where $\lambda$ is the wavelength, GNI is the global radiation, EQE is the quantum efficiency of the photovoltaic cell, q is the charge of the electron, h is the Planck constant and c is the speed of light and Transmission$_{filter}$ is the integrated transmission of the filter for the solar spectrum to be optimised.

By integrating Jsc throughout the entire solar spectrum with the help of Eq. 2.16 and 2.17 and by calculating the typical PR of a photovoltaic plant as in Eq. 2.14, the calculation of the photovoltaic efficiency of the initial filter j via Eq 2.13: $Ef_{PVj}$ is complete:

Similarly, to calculate the solar thermal efficiency of the initial filter j, $Ef_{CSPj}$, the following expression is used:

$$Ef_{CSP} = Ef_{AV} x \frac{DNI}{GNI} x Reflectance_{filter}$$

(Eq.2.18)

where:

- $Ef_{Av}$ is the annual average efficiency of a concentrated solar power (CSP) plant, normally between 15-20% depending on the type of plant. That is typically calculated through the following expression (Eq. 2.19) in which the factors that are multiplied for the calculation are the efficiency of the solar field, the efficiency of the turbine power cycle and the loss of efficiency of the plant due to self-consumption of equipment:

$$Ef_{av} = \eta_{solar\ field} x\ \eta_{power\ cycle} x\ \eta_{self-consumption}\ \text{(Eq.2.19)}$$

The efficiency of the solar field would be calculated according to the following expression:

$$\eta_{solar\ field} = \eta_{cos} x\ \eta_{shadows} x\ \eta_{attenuation} x\ \eta_{blockages} x$$

$$x\ \eta_{overflow} x\ \eta_{thermal\ receiver} x\ \eta_{dumping}\ \text{(Eq.2.20)}$$

Where the multiplicative factors of Eq. 2.20 represent the following concepts: efficiency by cosine factor (de-targeting with respect to the normal cosine factor of the sun); shadows between adjacent collectors; energy losses due to atmospheric attenuation; blockages (reflected energy that does not reach the thermal receiver due to its impact on adjacent collectors); overflow losses (reflected light that is not blocked does not hit the heat sink as the sensors are out of alignment or working outside of their allowable tolerance range); loss of light-thermal energy conversion in the receiver and, lastly, energy that is not introduced into the receiver as it does not accept more thermal load and the collectors are completely de-targeted.

- DNI/GNI is the ratio of direct radiation vs. global radiation.
- Reflectance$_{filter}$ is the integrated reflectance of the multilayer filter for the solar spectrum to be optimised, which is typically calculated using the following expression:

$$Reflectance_{filter} = \frac{\Sigma_\lambda\ x\ DNI(\lambda) x\ R\ (\lambda)}{DNI}$$

(Eq.2.20)

In this way, for the initial filter j, a merit function $Ef_{total\ j}$ can be obtained according to Eq. 2.12 and with the help of the set of expressions Eq. 2.1-2.11 and Eq. 2.13-2.20. This merit function calculated for the initial filter j is recorded at this stage.

3.- Optimising the thickness of the layers (2) for a determined number of layers (2).

In the next step, a set of initial filters, j=2,..., J is defined, with the same number L of layers (2) as the first initial filter, j=1, but with different random thicknesses for the L layers (2):

$$t_{ii} = \{t_{ii}\}=\{t_{1j}, t_{2j},..., t_{Lj}\} \text{ (Eq. 3.1)}$$

In this way, each $\{t_{ij}\}$ is a different set of random thicknesses for a given number L of layers (2), where there are J sets of random thicknesses, one for each initial filter j: $\{t_{j1}\}$, $\{t_{j2}\}$, ..., $\{t_{jJ}\}$.

For each of these initial filters j, with their thickness $\{t_{ij}\}$, all the calculations from the previous step are repeated; that is, the initial filter response is calculated using the equations Eq. 2.1-2.20, recording all the resulting merit functions, obtaining a set of J merit functions: $\{Ef_{total\,j}\}$ with j=1, ..., J.

Subsequently, the optimal filter (1) j=M, belonging to the aforementioned set of filters, is chosen, in such a way that said optimal filter (1) M comprises the combination of thicknesses $\{t_{iM}\}$ that maximises the merit function $Ef_{total\,M}$ for a given number L of layers (2), out of all the merit functions calculated in the preceding step.

The multilayer filter (1) method of configuration is therefore capable of quantifying the merit function until the optimal filter (1) for a defined number L of layers (2) is found.

4.- Optimising the number of layers (2).

The method of the invention may include a final step in which an optimal filter (1) is calculated for several amounts of different layers; that is, by varying the parameter L, to then choose one of said optimal filters (1).

For this, a secondary set, **s**=$\{L_1, ..., L_s\}$, of initial filters is defined , each one of those filters with a number $L_s$ of layers (2) different from each other, as well as different from the number L of layers (2) of the first initial filter j, with known refractive indices and with a random thickness of each layer (2):

$$\mathbf{s}=\{s\}=\{L_1,..., L_s\} \qquad \text{(Eq. 4.1)}$$

$$\mathbf{t_{ij}}=\{t_{ij}\}=\{t_{1j}, t_{2j},..., t_{Ls\,j}\} \qquad \text{(Eq. 4.2)}$$

$$\mathbf{N_i}=\{N_i\}=\{N_1, N_2,..., N_{LS}\} \qquad \text{(Eq. 4.3)}$$

Where i=1, ..., $L_s$ is the layer (2) in question and $t_{ij}$ is the random initial thickness of layer (2), i, of the initial filter, j, now belonging to the set, **s.** Each layer (2) also has a complex refractive index, $N_i$, known over a specified wavelength range.

The calculations in steps 2 and 3 are repeated for each of these initial filters, j, of the secondary set, **s**=$\{L_1,..., L_s\}$, to obtain an optimal filter (1) of the secondary filter set for each number, $L_s$, of layers (2) given and these results are recorded.

Lastly, a final filter is chosen from the entire set of optimal filters (1), which meets other technical criteria, such as the amount of material available for its manufacture, the possible precision in the thickness of the layers at the time they are deposited or the desired minimum efficiency. Thus, not all optimal filters (1) have to be equally efficient for a different number of $L_s$ layers. For example, an optimal filter (1) with $L_s$=20 layers can have high efficiency and an optimal filter (1) with $L_s$=5 layers can have an efficiency only a small percentage below the previous one. In this case, the optimal filter (1) with the least number of layers can be chosen as the final filter, due to its simplicity when manufacturing it. Alternatively, other selection criteria for a final filter can be established, depending on technical needs.

The method for configuring an optimal multilayer filter (1) that maximises the merit function defined in Eq. 2.12 described above, therefore deals with the resolution of a complex mathematical problem that includes fields of optics, semiconductors, solar PV and solar CSP power. The method of the invention provides a way to find highly efficient, technically and economically feasible solutions to configure a selective filter (1) for sunlight. Addressing this problem using conventional designs, applying the state-of-the-art quarter-wavelength theory, does not enable a solution to be reached that is as precise and efficient as with the method described in the preceding paragraphs.

According to the method of the invention, the light selective filter (1) will typically have an aperiodic design (given that a periodic design is not necessarily more efficient), formed by a pair of transparent high-low refractive index oxides, which solves the shortcomings in the state of the art and presents a series of advantages:

- Being an aperiodic design, the number of layers (2) necessary for optimisation is greatly simplified, which results in simplicity and a very low manufacturing cost. Figure 4 shows the reflectance curve and the transmittance curve for configuration of the filter (1) of only 7 layers, which improves efficiency, simplifies manufacturing and, additionally, reduces costs, given that less deposition on the substrate (3) and less material are needed.

- It is a much more efficient design than heat-films or hot mirrors, given that it spectrally selects which wavelength range or ranges to transmit or reflect in order to maximise the joint efficiency of the system. The wavelength ranges of hot mirrors or heat reflective films are not adjusted to maximise the efficiency of the photovoltaic and solar thermal (PV+CSP) system.

- The aperiodic design makes it possible to discern the areas of the solar spectrum in which the photovoltaic cell (4) receives radiation, being able to not reflect the radiation in infrared areas that do not receive solar radiation due to the absorption peaks of water vapour.

- It allows for greater spectral sensitivity with fewer layers (2) when transmitting or reflecting light, which, again, has a better efficiency/cost ratio. As can be seen in Figure 4, the reflectance/transmittance of these filters (1) differs from that of a heat film or hot-mirror. Firstly, the transmittance is very high, up to approximately 1,000 nm, given that up to that wavelength, the energy that would be obtained via a photovoltaic transformation is more efficient than solar thermal transformation. In addition, a very pronounced reflection peak of between 400-500 nm is observed, which gives it a very distinctive bluish tone with respect to a heat-film and which also maximises the total efficiency of the system given that, within these ranges, the photovoltaic cell (4) it is not very efficient.

Another aim of the invention relates to a multilayer filter (1) configured via the method described above. Preferably, the layers (2) comprising the filter (1) are a pair of transparent high-low refractive index oxides and can be deposited directly onto a glass of a photovoltaic module, more preferably on its internal side, so that it is protected from external conditions.

The characteristics of a selective multilayer solar radiation filter (1), apt to maximise the integrated efficiency of a PV-CSP plant according to a preferred embodiment of the invention, are generally described below:

In a preferred embodiment of the light selective filter (1) of the invention, said filter (1) is dichroic. With said dichroic filter (1), a differentiated treatment of sunlight according to wavelength is achieved, so that a fraction of the spectrum is selectively reflected, whilst the other fraction is transmitted through it; that is, it is an optical filter (1) used to selectively reflect or transmit light according to its wavelength. The cut-off wavelength is chosen at will according to need.

In general, the dichroic filter (1) comprises a stack of layers (2) of two transparent materials (in the visible or within a range of wavelengths) of different refractive index. The low index layer/high index layer assembly may have a periodic or aperiodic sequence, depending on the characteristics of the desired reflection and transmission spectra.

Even more preferably, the dichroic filter (1) of the invention is manufactured by sputtering techniques and its design will be defined by the following formula or expression:

$$\text{Substrate} / (a_1A) / (b_1B) / (a_2A) / (b_2B)/.../ (a_nA) / (b_nB) \quad (Eq. 5.1)$$

Where the bar "/" represents an interface between layers (2), where A is the high index material and B is that of low refractive index and where $a_i$ and $b_i$ are the specific thicknesses of the layers (2). In the case of periodic designs, $a_1=a_2=....=a_n$ and $b_1=b_2=.....=b_n$, whilst in the case of aperiodic designs, the thicknesses will have different values, the latter being optimal for solar applications, given that they generate, not only interferential reflections caused by a periodic design, but also allow different reflections to be obtained in each layer and increase the number of combinations. This complexity may appear to be disadvantage a priori, although it is precisely what allows the filter (1) to be configured according to the desired requirements, by means of a powerful calculation tool.

In another preferred embodiment of the invention, the filter (1) is configured to allow the solar radiation of visible wavelengths to pass into the corresponding photovoltaic cell (4) and to reflect the solar radiation of wavelengths in the blue region and from 950-1,000 nm to the central receiver (5).

A spectral graph of the wavelengths reflected by the filter (1) of the invention is shown in Figure 4, according to a preferred embodiment thereof.

More preferably, the dichroic filter (1) comprises layers of high/low refractive index transparent oxides (in a wavelength range like that of the visible range) laminated onto the photovoltaic cell (4). Said layers of transparent oxides are deposited on glass substrates by sputtering, which is ideally laminated on photovoltaic cells (3). Even more preferably, said oxides are silicon oxide as a low refractive index element and titanium oxide as a high refractive index element.

Even more preferably the thicknesses of both silicon oxide and titanium oxide will be between 5 and 500 nm.

The operation of the reflection and transmission of sunlight in a multilayer filter (1) like that of the invention, resembles that of Figure 3, where a possible longitudinal section of an aperiodic filter (1) is shown under the transparent cover of a photovoltaic cell (4). In such a multilayer structure, the incident ray of light (100) undergoes reflection and refraction processes in all the interfaces (2') that exist between the different layers (2) and between the last layer (2) and the inner air and the first layer (2) and the substrate (3) that configure the transparent cover, so that the reflected parts (102) in the different interfaces (2') leave the filter (1) forming a reflected beam (101) in which, given that each reflected part (102) travels different optical paths, it has generated optical interference processes that remove certain ranges of wavelengths in the resulting reflected beam (101). This non-reflected wavelength range will precisely be the part of light transmitted (104) to the photovoltaic cell (4).

Preferably, the number of layers (2) is from 1 to 20. More preferably, the number of layers (2) is from 3 to 10 and, even more preferably, from 5 to 7.

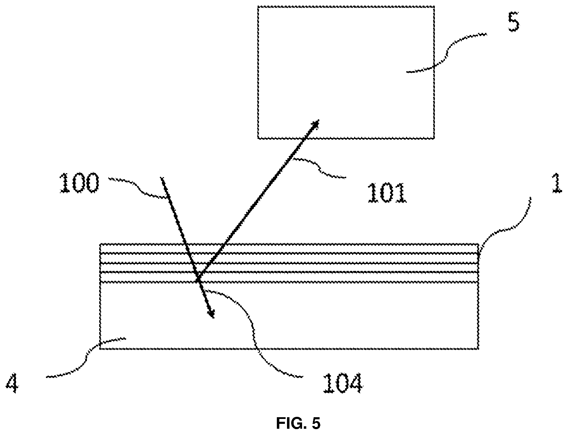

Another aim of the invention (Figure 5) refers to the inclusion of this type of filters (1) in hybrid solar plants formed by modules or photovoltaic cells (4), which absorb part of the sunlight by injecting it into the network in the same way as a conventional photovoltaic plant; and, on the other hand, they reflect infrared rays and others within the visible spectrum to a central receiver solar thermal power plant (5) (PV-CSP solar power plant), which adds a new dimension to technology and solves the problems resulting from the current state of the art.

Therefore, as described, these filters (1) are designed with complex genetic algorithms that select the optimal combination of thicknesses for layers (2) from millions of possible combinations to maximise the sum of the efficiency in transforming the solar radiation within the photovoltaic range (the wavelength range where the silicon semiconductor typically absorbs photons to convert them into electrical energy) and the efficiency in transforming solar radiation within the concentrated solar thermal power range (PV + CSP).

None of the optimal solutions is based on a periodic design, which greatly limits the configuration options of the multilayer filter (1). In this way, the invention proposes a solution that overcomes the technical problems posed by providing an aperiodic ad-hoc filter (1) to selectively reflect and transmit sunlight. Additionally, many layers (2) are not necessary to find optimal solutions at the global PV + CSP performance level, which gives the product viability for solar applications at an industrial level due to the high efficiency achieved through the configuration obtained by the method of the invention. This type of solution is based on very powerful computing systems to optimise the described merit function, which moves away from the traditional design theory and methods for interferential filters, overcoming the difficulties of the state of the art.

## Claims

1.   Method for configuring a selective multilayer spectral-separation filter (1) for solar radiation, suitable for placement on photovoltaic panels for use in concentrating solar power plants, where the multilayer filter (1) comprises multiple layers (2) of different refractive indices and thicknesses, where said method is **characterised by the fact that** it involves the performance of the following steps to configure said multilayer filter (1) in terms of a desired transmittance and reflectance within a range of wavelengths:

   a) a first initial filter is defined with a number of layers (2) and refractive indices of known layers (2), with a random thickness of each layer (2), said layers being assumed deposited layer-by-layer on a substrate (3) of known optical admittance;

   b) the transmittance and reflectance response of said filter within the desired wavelength range is calculated according to the optical admittance of the filter and the optical admittance of air;

   c) the photovoltaic efficiency of said filter is calculated according to the transmittance calculated in step b) within the desired wavelength range; where the photovoltaic efficiency is calculated by multiplying a typical performance ratio of a photovoltaic plant by the efficiency of the photovoltaic cell according to its spectral response $Ef_{cel,}$ the efficiency of the photovoltaic cell being defined by the equation

$$Ef_{cel} = \frac{J_{sc} \times V_{OC} \times FF}{GNI} \quad \text{(Eq.2.15)}$$

where $J_{sc}$ is the current density of the photovoltaic cell, GNI is the global normal irradiance, $V_{oc}$ is the open circuit voltage of the cell and FF is the fill factor and $J_{sc}$ may be defined by the expressions

$$J_{sc} = \Sigma_\lambda J_{sc}(\lambda) \quad \text{(Eq. 2.16)}$$

$$Jsc\,(\lambda) = \lambda x GNI(\lambda) x EQE x Transmission_{filter}(\lambda) x \frac{q}{hxc}$$

$$\text{(Eq.2.17)}$$

where $\lambda$ is the wavelength, GNI is the global normal irradiance, EQE is the quantum efficiency of the photovoltaic cell, q is the charge of the electron, h is the Planck constant and c is the speed of light and Transmission$_{filter}$ is the integrated transmission of the filter for the wavelength;

d) the thermal efficiency $Ef_{CSP}$ of said filter is calculated according to the reflectance calculated in step b) within the desired wavelength range; where:

- thermal efficiency is calculated by multiplying the average annual efficiency of a concentrated solar thermal power plant $Ef_{AV}$ by the ratio of direct radiation DNI versus direct radiation added to diffuse radiation DNI/GNI, by the integrated reflectance of the filter for the desired wavelength range;

$$Ef_{CSP} = Ef_{AV} x \frac{DNI}{GNI} x Reflectance_{filter}$$

; and
- the annual average efficiency of a concentrated solar power plant $Ef_{AV}$ is calculated by multiplying the factors: solar field efficiency $\eta_{solar\ field}$, cycle efficiency of turbine power block $\eta_{power\ cycle}$ and loss of plant efficiency due to equipment self-consumption $\eta_{self-consumption}$;

$$Ef_{av} = \eta_{solar\ field} x\ \eta_{power\ cycle} x\ \eta_{self-consumption}\ (Eq.2.19)$$

e) a merit function is calculated and recorded, calculated as the sum of the photovoltaic and thermal efficiencies resulting from steps c) and d);

f) further sets of initial filters are defined with the same number of layers (2) as the first initial filter but with different thicknesses for the layers (2) of each of said filters with respect to the first initial filter and steps b) to e) are repeated for each of said further sets of initial filters;

g) the optimal multilayer filter (1) is selected, belonging to the sets of filters in stage f) plus the first initial filter, where said optimal multilayer filter (1) comprises the combination of thicknesses that maximises the merit function for a given number of layers (2), out of all of the merit functions calculated in step e).

2. Method for configuring a selective multilayer spectral-separation filter (1) for solar radiation, according to the preceding claim, which further comprises an additional stage, where:

- a set of secondary filters is defined, each of those filters with a different number of layers (2) from each other as well as with a different number of layers (2) of the first initial filter, with known refractive indices and with a random thickness of each layer (2);
- steps b) to g) are repeated to obtain an optimal multilayer filter (1) of the secondary filter set for each given number of layers (2).

3. Method for configuring a selective multilayer spectral-separation filter (1) for solar radiation, according to the preceding claim, which also includes an additional stage, where:

- a desired critical merit function is established;
- a desired critical number of layers (2) is established;
- a final optimal filter (1) is selected from amongst all of the registered optimal filters (1) in such a way that said final optimal filter (1) is that which is closest to the established criteria of said critical merit function and said critical number of layers (2).

4. Method for configuring a selective multilayer spectral-separation filter (1) for solar radiation, according to any of the preceding claims, where, in step b), the transmittance and reflectance response of said filter within the desired range of wavelengths is calculated by calculating at least the following parameters:

- the characteristic matrix of a multilayer system;
- the phase term according to the wavelength, the thickness of the layer (2) and the angle of incidence;
- the complex refractive index of a multilayer system;
- the optical admittance of a substrate (3) in which a multilayer deposition is carried out to build the multilayer filter (1).

5. Method for configuring a selective multilayer spectral-separation filter (1) for solar radiation, according to any of the previous claims, where: in step c), the current density is calculated from the wavelength and of the quantum efficiency of the cell.

**Patentansprüche**

1.  - Verfahren zum Konfigurieren eines selektiven mehrschichtigen spektralen Trennfilters (1) für Sonnenstrahlung, geeignet zum Anbringen an photovoltaischen Paneelen zur Verwendung in konzentrierenden Solarkraftwerken, wobei das mehrschichtige Filter (1) mehrere Schichten (2) unterschiedlicher Brechung umfasst Indizes und Dicken, wobei das Verfahren **dadurch gekennzeichnet ist, dass** es die Ausführung der folgenden Schritte beinhaltet, um das Mehrschichtfilter (1) hinsichtlich einer gewünschten Durchlässigkeit und Reflexion innerhalb eines Bereichs von Wellenlängen zu konfigurieren:

    a) ein erstes Anfangsfilter wird mit einer Anzahl von Schichten (2) und Brechungsindizes bekannter Schichten (2) mit zufälliger Dicke jeder Schicht (2) definiert, wobei die Schichten als schichtweise auf einem Substrat abgeschieden angenommen werden (3) mit bekannter optischer Admittanz;
    b) das Transmissions- und Reflexionsverhalten des Filters innerhalb des gewünschten Wellenlängenbereichs gemäß der optischen Admittanz des Filters und der optischen Admittanz von Luft berechnet wird;
    c) der photovoltaische Wirkungsgrad des Filters wird gemäß der in Schritt b) berechneten Durchlässigkeit innerhalb des gewünschten Wellenlängenbereichs berechnet;
    wobei der photovoltaische Wirkungsgrad berechnet wird, indem ein typisches Leistungsverhältnis einer photovoltaischen Anlage mit dem Wirkungsgrad der photovoltaischen Zelle gemäß ihrer spektralen Empfindlichkeit $Ef_{cel}$ multipliziert wird, wobei der Wirkungsgrad der photovoltaischen Zelle durch die Gleichung definiert ist

$$Ef_{cel} = \frac{J_{sc} \times V_{oc} \times FF}{GNI} \quad (Eq.2.15)$$

wo $J_{sc}$ ist die Stromdichte der Photovoltaikzelle, GNI ist die globale Normalstrahlung, $V_{oc}$ ist die Leerlaufspannung der Zelle und FF ist der Füllfaktor und $J_{sc}$ kann durch die Ausdrücke definiert werden

$$J_{sc} = \Sigma_{\lambda} J_{sc}(\lambda) \quad (Eq. 2.16)$$ ;

$$Jsc\ (\lambda) = \lambda \times GNI(\lambda) \times EQE \times Transmissionfilter(\lambda) \times \frac{q}{h \times c}$$

$$(Eq.2.17)$$

wobei $\lambda$ die Wellenlänge ist, GNI die globale Normalstrahlung ist, EQE die Quanteneffizienz der Photovoltaikzelle ist, q die Ladung des Elektrons ist, h ist die Planck-Konstante und c die Lichtgeschwindigkeit und Transmissions$_{filter}$ die integrierte Transmission des Filters für die Wellenlänge;
    d) der thermische Wirkungsgrad $Ef_{CSP}$ des Filters wird gemäß dem in Schritt b) berechneten Reflexionsvermögen innerhalb des gewünschten Wellenlängenbereichs berechnet; Wo:

    - der thermische Wirkungsgrad wird berechnet, indem der durchschnittliche Jahreswirkungsgrad eines konzentrierten solarthermischen Kraftwerks $Ef_{AV}$ mit dem Verhältnis von Direktstrahlung DNI zu Direktstrahlung addiert zur Diffusstrahlung DNI/BNI, mit dem integrierten Reflexionsgrad des Filters für den gewünschten Wellenlängenbereich multipliziert wird

$$Ef_{CSP} = Ef_{AV \times \frac{DNI}{BNE}} \times Reflexions_{filter}$$

    - ; und
    - der Jahresdurchschnittswirkungsgrad eines solarthermischen Kraftwerks $Ef_{AV}$ errechnet sich aus der Multiplikation der Faktoren: Solarfeldwirkungsgrad $\eta_{Solarfeld}$, Kreislaufwirkungsgrad des Turbinenblocks $\eta_{Leistungskreislauf}$ und Anlagenwirkungsgradverlust durch Geräteeigenverbrauch $\eta_{Eigenverbrauch}$;

$$Ef_{av} = \eta_{Solarfeld} \times \eta_{Leistungszyklus} \times \eta_{Eigenverbrauch} \quad (Gl.2.19)$$

e) eine Gütefunktion wird berechnet und aufgezeichnet, berechnet als die Summe der photovoltaischen und thermischen Wirkungsgrade, die sich aus den Schritten c) und d) ergeben;t

f) weitere Sätze von Anfangsfiltern werden mit der gleichen Anzahl von Schichten (2) wie der erste Anfangsfilter, aber mit unterschiedlichen Dicken für die Schichten (2) jedes der Filter in Bezug auf den ersten Anfangsfilter und die Schritte b) bis e) definiert, für jeden der weiteren Sätze von Anfangsfiltern wiederholt werden;

g) der optimale mehrschichtige Filter (1) ausgewählt wird, der zu den Filtersätzen in Stufe f) plus dem ersten anfänglichen Filter gehört, wobei der optimale mehrschichtige Filter (1) die Kombination von Dicken umfasst, die die Gütefunktion für eine gegebene Anzahl von Schichten maximiert (2) aus allen in Schritt e) berechneten Gütefunktionen.

2. - Verfahren zum Konfigurieren eines selektiven mehrschichtigen Spektraltrennfilters (1) für Sonnenstrahlung nach dem vorhergehenden Anspruch, das ferner einen zusätzlichen Schritt umfasst, wobei:

- ein Satz sekundärer Filter definiert wird, wobei jeder dieser Filter eine voneinander unterschiedliche Anzahl von Schichten (2) sowie eine unterschiedliche Anzahl von Schichten (2) des ersten Anfangsfilters, mit bekannten Brechungsindizes und mit a zufällige Dicke jeder Schicht (2);

- die Schritte b) bis g) wiederholt werden, um einen optimalen Mehrschichtfilter (1) des Sekundärfiltersatzes für jede gegebene Anzahl von Schichten (2) zu erhalten.

3. - Verfahren zum Aufbau eines selektiven mehrschichtigen Spektraltrennfilters (1) für Sonnenstrahlung nach dem vorhergehenden Anspruch, das auch einen zusätzlichen Schritt umfasst, wobei:

- eine gewünschte kritische Gütefunktion wird aufgestellt;

- eine gewünschte kritische Lagenzahl (2) eingestellt wird;

- ein endgültiges optimales Filter (1) aus allen registrierten optimalen Filtern (1) derart ausgewählt wird, dass das endgültige optimale Filter (1) dasjenige ist, das den festgelegten Kriterien der kritischen Gütefunktion und dem kritischen am nächsten kommt Anzahl der Schichten (2).

4. - Verfahren zum Konfigurieren eines selektiven mehrschichtigen spektralen Trennfilters (1) für Sonnenstrahlung nach einem der vorhergehenden Ansprüche, wobei in Schritt b) das Transmissions- und Reflexionsverhalten des Filters innerhalb des gewünschten Wellenlängenbereichs berechnet wird durch Berechnung mindestens der folgenden Parameter:

- die charakteristische Matrix eines Mehrschichtsystems;

- der Phasenterm entsprechend der Wellenlänge, der Dicke der Schicht (2) und dem Einfallswinkel;

- der komplexe Brechungsindex eines Mehrschichtsystems;

- die optische Admittanz eines Substrats (3), in dem eine Mehrschichtabscheidung durchgeführt wird, um das Mehrschichtfilter (1) aufzubauen.

5. - Verfahren zum Konfigurieren eines selektiven mehrschichtigen Spektraltrennfilters (1) für Sonnenstrahlung nach einem der vorhergehenden Ansprüche, wobei: in Schritt c) die Stromdichte aus der Wellenlänge und der Quanteneffizienz der Zelle berechnet wird.

**Revendications**

1. Procédé de configuration d'un filtre de séparation spectrale multicouche sélectif (1) pour le rayonnement solaire, adapté pour être placé sur des panneaux photovoltaïques destinés à être utilisés dans des centrales solaires à concentration, le filtre multicouche (1) comprenant plusieurs couches (2) d'indices de réfraction et d'épaisseurs différents , où ledit procédé est **caractérisé par le fait qu'**il implique l'exécution des étapes suivantes pour configurer ledit filtre multicouche (1) en termes de transmittance et de réflectance souhaitées dans une plage de longueurs d'onde;

a) un premier filtre initial est défini avec un nombre de couches (2) et d'indices de réfraction de couches (2) connus, avec une épaisseur aléatoire de chaque couche (2), lesdites couches étant supposées déposées couche par couche sur un substrat (3) d'admittance optique connue:

b) la réponse de transmission et de réflexion dudit filtre dans la plage de longueurs d'onde souhaitée est calculée en fonction de l'admittance optique du filtre et de l'admittance optique de l'air;

c) le rendement photovoltaïque dudit filtre est calculé en fonction de la transmittance calculée à l'étape b) dans la plage de longueur d'onde souhaitée;

où l'efficacité photovoltaïque est calculée en multipliant un rapport de performance typique d'une installation photovoltaïque par l'efficacité de la cellule photovoltaïque en fonction de sa réponse spectrale $Ef_{cel}$,

$$Ef_{cel} = \frac{J_{sc} \times V_{oc} \times FF}{GNI} \quad \text{(Eq.2.15)}$$

où $J_{sc}$ est la densité de courant de la cellule photovoltaïque, GNI est l'irradiance normale globale, $V_{oc}$ est la tension en circuit ouvert de la cellule et FF est le facteur de remplissage et $J_{sc}$ peut être défini par les expressions

$$J_{sc} = \Sigma_\lambda J_{sc}(\lambda) \quad \text{(Eq. 2.16)}$$

$$Jsc\ (\lambda) = \lambda \times GNI(\lambda) \times EQE \times Transmission_{filter}(\lambda) \times \frac{q}{h \times c}$$

$$\text{(Eq.2.17)}$$

où $\lambda$ est la longueur d'onde, GNI est l'éclairement énergétique normal global, EQE est l'efficacité quantique de la cellule photovoltaïque, q est la charge de l'électron, h est la constante de Planck et c est la vitesse de la lumière et Transmission$_{filter}$ est la transmission intégrée du filtre pour la longueur d'onde ;

d) l'efficacité thermique $Ef_{CSP}$ dudit filtre est calculée en fonction de la réflectance calculée à l'étape b) dans la plage de longueur d'onde souhaitée; où:

- l'efficacité thermique est calculée en multipliant l'efficacité annuelle moyenne d'une centrale solaire thermique à concentration $Ef_{AV}$ par le rapport entre le rayonnement direct DNI et le rayonnement direct ajouté au rayonnement diffus DNI/GNI, par la réflectance intégrée du filtre pour la gamme de longueurs d'onde souhaitée

$$Ef_{CSP} = Ef_{AV} \times \frac{DNI}{GNI} \times Reflectance_{filter}$$

- ; et

- le rendement moyen annuel d'une centrale solaire à concentration $Ef_{AV}$ est calculé en multipliant les facteurs : rendement du champ solaire $\eta_{champ\ solaire}$, rendement du cycle du bloc de puissance de la turbine $\eta_{cycle\ de\ puissance}$ et perte de rendement de la centrale due à l'autoconsommation des équipements $\eta_{autoconsommation}$ ;

$$Ef_{av} = \eta_{solar\ field} \times \eta_{power\ cycle} \times \eta_{self\text{-}consumption} \quad \text{(Eq.2.19)}$$

e) une fonction de mérite est calculée et enregistrée, calculée comme la somme des rendements photovoltaïque et thermique résultant des étapes c) et d) ;

f) d'autres ensembles de filtres initiaux sont définis avec le même nombre de couches (2) que le premier filtre initial mais avec des épaisseurs différentes pour les couches (2) de chacun desdits filtres par rapport au premier filtre initial et les étapes b) à e) sont répétés pour chacun desdits autres ensembles de filtres initiaux;

g) le filtre multicouche optimal (1) est sélectionné, appartenant aux ensembles de filtres de l'étape f) plus le premier filtre initial, ledit filtre multicouche optimal (1) comprenant la combinaison d'épaisseurs qui maximise la fonction de mérite pour un nombre donné de couches (2), parmi toutes les fonctions de mérite calculées à l'étape e).

2. Procédé de configuration d'un filtre multicouche sélectif de séparation spectrale (1) du rayonnement solaire, selon la revendication précédente, qui comprend en outre une étape supplémentaire, où :

- un ensemble de filtres secondaires est défini, chacun de ces filtres avec un nombre de couches (2) différent les uns des autres ainsi qu'avec un nombre de couches (2) différent du premier filtre initial, avec des indices de réfraction connus et avec une épaisseur de chaque couche (2);
- les étapes b) à g) sont répétées pour obtenir un filtre multicouche optimal (1) de l'ensemble de filtres secondaires pour chaque nombre donné de couches (2).

3. - Procédé de configuration d'un filtre multicouche sélectif de séparation spectrale (1) du rayonnement solaire, selon la revendication précédente, qui comprend en outre une étape supplémentaire, où :

- une fonction de mérite critique souhaitée est établie ;
- un nombre critique souhaité de couches (2) est établi ;
- un filtre optimal final (1) est sélectionné parmi tous les filtres optimaux enregistrés (1) de telle manière que ledit filtre optimal final (1) est celui qui est le plus proche des critères établis de ladite fonction de mérite critique et dudit filtre critique nombre de couches (2).

4. - Procédé de configuration d'un filtre de séparation spectrale multicouche sélectif (1) pour le rayonnement solaire, selon l'une quelconque des revendications précédentes, dans lequel, à l'étape b), la réponse en transmission et en réflectance dudit filtre dans la plage de longueurs d'onde souhaitée est calculée en calculant au moins les paramètres suivants :

- la matrice caractéristique d'un système multicouche ;
- le terme de phase en fonction de la longueur d'onde, de l'épaisseur de la couche (2) et de l'angle d'incidence ;
- l'indice de réfraction complexe d'un système multicouche ;
- l'admittance optique d'un substrat (3) dans lequel un dépôt multicouche est réalisé pour construire le filtre multicouche (1).

5. - Procédé de configuration d'un filtre multicouche sélectif de séparation spectrale (1) du rayonnement solaire, selon l'une quelconque des revendications précédentes, dans lequel : à l'étape c), la densité de courant est calculée à partir de la longueur d'onde et du rendement quantique de la cellule.

FIG. 1

FIG. 2

FIG. 3

FIG. 4

FIG. 5

## REFERENCES CITED IN THE DESCRIPTION

**Patent documents cited in the description**

- JP 2009218383 B
- US 20150083194 A
- WO 2015117134 A1
- ES 2636800 A1